# EUROPEAN PATENT APPLICATION

(11) **EP 2 455 979 A1**
(43) Date of publication of application: **23.05.2012**
(21) Application number: 10799824.7
(22) Date of filing: 12.07.2010
(51) Int. Cl.: H01L 31/042, C08F 2/28, C09D 5/02, C09D 133/10, C09K 3/10

(54) **SEALING AGENT SHEET FOR SOLAR CELLS AND SEALING AGENT-INTEGRATED BASE MATERIAL**

(30) Priority: 15.07.2009 JP 2009166615
(71) Applicant: NHK Spring Co., Ltd., Kanagawa 236-0004 (JP)
(72) Inventor: ICHIMURA, Shigeki, Yokohama-shi Kanagawa 236-0004 (JP); NATSUME, Yutaka, Yokohama-shi Kanagawa 236-0004 (JP)
(74) Representative: HOFFMANN EITLE
(86) International application number: PCT/JP2010/061802
(87) International publication number: WO 2011/007766

(57) **Abstract**

The solar cell sealant sheet of the present invention includes a coating film of a water-soluble thermosetting resin-dispersed paint obtained by emulsion-polymerizing a monomer mixture containing an α,β-ethylenically unsaturated monomer having an alkoxysilyl group in a presence of a resin serving as a dispersant, the resin having a quaternized ammonium group that has been obtained by addition of a tertiary amine compound and an organic acid to having an epoxy group, wherein a hardness (B) in terms of a pencil hardness of the coating film after being thermally cured is 4B or higher, and a hardness ratio (B/A) of the hardness (B) after being thermally cured relative to a hardness (A) before being heated is 1.1 or higher. The sealant-integrated substrate of the present invention includes, as a sealant, the coating film of the water-soluble thermosetting resin-dispersed paint that is integrally layered on a surface on a solar cell element side of a substrate of a solar cell module.

## Description

### Field

The present invention relates to a solar cell sealant sheet and a sealant-integrated substrate for use in a solar cell module.

### Background

A solar cell module has, as basic elements, a solar cell element, a protection sheet member supporting the solar cell element (a back sheet), and a transparent light receiving plate (such as a glass plate) provided on the light receiving side of the solar cell element. In the solar cell module, the solar cell element is sealed between the protection sheet and the transparent light receiving plate for protecting the solar cell element from the external environment. This sealing structure is realized by forming a layered body and then giving a shape to the layered body by vacuum-pressure molding with application of heat, wherein the layered body is formed by interposing a sealant sheet made of an ethylene vinyl acetate (EVA) resin between the transparent light receiving plate and the solar cell element, and between the protection sheet member and the solar cell element.

In related-art solar cell modules, sheets formed of an EVA resin composition are used as the sealant sheets as described above. However, the EVA resin sheet basically tends to cause deterioration and change of properties, such as yellowing, cracks, and bubbles, when used for a long period of time. The occurrence of the deterioration and change of properties of the sealant sheet triggers corrosion of the solar cell element. When the corrosion of the solar cell element begins, the power generation capacity of the solar cell module decreases drastically. When environmental conditions for using the solar cell module change into more severe state, the occurrence of such phenomena of the deterioration and the change of properties tends to increase. Such susceptibility to the usage environment also causes limitation in applications of the related-art solar cells.

It is presumed that the deterioration and change of properties of the EVA resin sheet with the lapse of time would be caused by problems related to the ingredients of the EVA resin composition which is the material of the EVA resin sheet, as well as problems related to the molecular structure of the resin component. That is, it is presumed that an ester structure having a high hydrolysis property, a cross-linker for thermal cross-linking such as an organic peroxide and a multifunctional vinyl compound, a residual cross-linker, a reaction product, and a higher carbon number compound and a reaction end of an EVA cross-link point would become an active spot, and the active spot gradually causes the deterioration and change of properties of the resin sheet.

As a measure to solve such problems, Patent Literature 1 discloses an adhesive sheet and a sheet for a solar cell filler which are made of an ethylene resin that has the same excellent properties as the EVA resin and hardly causes the deterioration and change of properties of the resin sheet. That is, Patent Literature 1 proposes use of a sheet member as the sealant sheet, wherein the sheet member is formed by extruding a graft polymer or a copolymer of alkoxysilane using an extruder into a single layer sheet or a layered sheet with a core member made of an ethylene resin. The sealant sheet is interposed between the back surface protection sheet (back sheet) and a glass plate serving as the light receiving side transparent plate so as to sandwich the solar cell element. The layered body obtained by interposing the sealant sheet is subjected to vacuum-pressure molding with application of heat (hereinafter, the process may be referred to as heat vacuum-pressure molding) so as to seal the solar cell element.

The method disclosed in Patent Literature 1, however, has a problem of an increased workload because the method requires a step to insert the sealant sheet in addition to insertion of the back sheet in the same manner as the related-art sealing method using the EVA resin as the sealant sheet.

The sealant sheet used in Patent Literature 1 is an adhesive sheet obtained by extrusion forming. This adhesive sheet is a moisture-curable sheet. Accordingly, increase in thickness of the adhesive layer of alkoxysilane exacerbates, upon module assembling, access of moisture necessary for curing the adhesive sheet to the central part in the thickness direction of the sheet, resulting in a shortage of moisture. With the shortage of moisture necessary to cure the adhesive sheet, the adhesive sheet is insufficiently cured in the time period for molding. The insufficiently cured part in the adhesive sheet melts and overflows. The melting and overflowing adhesive resin in a plasticized state sticks to an assembly board surface of a molding apparatus, to cause contamination. Therefore it is necessary to clean the board surface after each molding, thereby resulting in a problem of extended period of time for carrying out the manufacturing steps.
This problem similarly occurs with a back sheet integrated with a sealant having a structure in which the EVA resin sheet is layered on the back sheet as a sealant layer. No drastic solution for this issue has yet been found.

### Citation List

### Patent Literature

Patent Literature 1: Japanese Patent Application Laid-open No. 2002-235048 A

### Summary

### Technical Problem

As described above, in the assembly of the solar cell module, the sealant sheets are interposed between the back surface protection sheet and the light receiving side transparent plate and sandwich the solar cell element, and the resulting layered body is subjected to the heat vacuum-pressure molding. The sealant sheet is once plasticized with heat in this vacuum-pressure molding, so as to be tightly bonded to the solar cell element. Thereafter, the sealant sheet is cured so as to seal the solar cell element. In this process, the use of the related-art sealant causes a problem in that the sealant in the plasticized state overflows to the periphery of the solar cell module, and sticks to the assembly apparatus, to cause contamination.
An object of the present invention is to provide a solar cell sealant sheet and a sealant-integrated substrate that can seal and bond a solar cell element without causing a problem in the assembly steps of the solar cell module in that the sealant in the plasticized state overflows to the periphery of a solar cell module, and sticks to an assembly apparatus, to cause contamination.

### Solution to Problem

In order to solve the aforementioned problems, the present invention provides a solar cell sealant sheet and a sealant-integrated substrate that employ the following features.

(1) A solar cell sealant sheet for sealing a solar cell element between two kinds of substrates that are a light receiving side transparent plate and a back surface protection sheet, the solar cell sealant sheet having a thermosetting property, the solar cell sealant sheet comprising:
a coating film of a water-soluble thermosetting resin-dispersed paint obtained by emulsion-polymerizing a monomer mixture containing an α,β-ethylenically unsaturated monomer having an alkoxysilyl group in a presence of a resin serving as a dispersant, said resin having a quaternized ammonium group that has been obtained by addition of a tertiary amine compound and an organic acid to having an epoxy group, wherein a hardness (B) in terms of a pencil hardness of the coating film after being thermally cured is 4B or higher, and a hardness ratio (B/A) of the hardness (B) after being thermally cured relative to a hardness (A) before being heated is 1.1 or higher.

(2) The solar cell sealant sheet according to the aforementioned (1), wherein the coating film has a thickness ranging from 30 µm to 400 µm.

(3) A sealant-integrated substrate for a solar cell that is for forming a solar cell module that has two kinds of substrates that are a light receiving side transparent plate and a back surface protection sheet, and a sealant that seals a solar cell element between the substrates,
the sealant-integrated substrate comprising, as the sealant, a coating film of a water-soluble thermosetting resin particle paint obtained by emulsion-polymerizing a monomer mixture containing an a,p-ethylenically unsaturated monomer having an alkoxysilyl group in a presence of a resin serving as a dispersant, said resin having a quaternized ammonium group that has been obtained by addition of a tertiary amine compound and an organic acid to having an epoxy group, wherein a hardness (B) in terms of a pencil hardness of the coating film after being thermally cured is 4B or higher, a hardness ratio (B/A) of the hardness (B) after being thermally cured relative to a hardness (A) before being heated is 1.1 or higher, and the coating film is integrally layered on a surface on a solar cell element side of the substrate.

(4) The sealant-integrated substrate for a solar cell according to the aforementioned (3), wherein the substrate on which the sealant is integrally layered is the light receiving side transparent plate.

(5) The sealant-integrated substrate for a solar cell according to the aforementioned (3), wherein the substrate on which the sealant is integrally layered is the back surface protection sheet.

(6) The sealant-integrated substrate for a solar cell according to any one of the aforementioned (3) to (5), wherein the coating film has a thickness ranging from 30 µm to 400 µm.

### Advantageous Effects of Invention

The solar cell sealant sheet and the sealant-integrated substrate according to the present invention have an effect that the solar cell element can be sealed and bonded without causing a problem in the assembly step of the solar cell module in that the sealant in the plasticized state overflows to the periphery of the solar cell module, sticks to the assembly apparatus, to cause contamination.

### Brief Description of Drawings

FIG. 1 is a cross-sectional structural view illustrating an example of a solar cell module formed by using a solar cell sealant sheet or a sealant-integrated substrate according to the present invention.
FIG. 2 is a cross-sectional structural view illustrating another example of a solar cell module formed by using the solar cell sealant sheet or the sealant-integrated substrate according to the present invention.

### Description of Embodiments

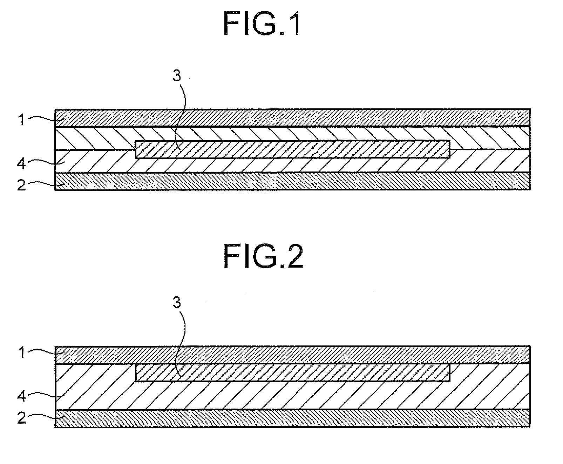

FIGS. 1 and 2 are cross-sectional structural views illustrating examples of a solar cell module formed by using a solar cell sealant sheet or a sealant-integrated substrate according to the present invention. In the solar cell module whose cross-sectional structure is illustrated in FIG. 1, a solar cell element 3 is sealed between a transparent plate 1 provided on the light receiving side and a back surface protection sheet 2 while sandwiched by a sealant 4. In the solar cell module whose cross-sectional structure is illustrated in FIG. 2, the solar cell element 3 is disposed so as to make contact with the transparent plate 1 provided on the light receiving side, and sealed with the sealant 4 filled between the transparent plate 1 and the back surface protection sheet 2.

In the present invention, the sealant 4 is obtained by thermally curing a coating film of a specific water-soluble thermosetting resin particle-dispersed paint, which is described later, or a sealant sheet of the coating film. The coating film is formed by applying the paint on a surface of the transparent plate 1 or/and the back surface protection sheet 2, wherein the surface is the one facing the solar cell element 3. In this case, the transparent plate 1 or the back surface protection sheet 2 with the coating film layered thereon corresponds to a sealant-integrated substrate defined in the present Invention. In the structure of FIG. 1, the coating film is layered on both the transparent plate 1 and the back surface protection sheet 2. In the structure of FIG. 2, the coating film is layered only on the back surface protection sheet 2.

The sealant sheet may be obtained by applying the paint on another resin sheet, drying the applied paint, and peeling the dried coating film off the resin sheet. In the structure of FIG. 1, two sealant sheets are prepared. Upon assembling the solar cell module, the two sealant sheets are disposed between the transparent plate 1 and the back surface protection sheet 2 so as to sandwich the solar cell element 3. Thereafter, a layered body composed of (the transparent plate 1)-(the sealant sheet)-(the solar cell element 3)-(the sealant sheet)-(the back surface protection sheet 2) is subjected to vacuum-pressure molding with application of heat, so that the sealant sheets of the layered body are thermally cured to be the sealant 4. In the structure of FIG. 2, the sealant sheet is disposed so as to cover the solar cell element 3 abutted to the transparent plate 1, and the back surface protection sheet 2 is disposed outside the sealant sheet. Thereafter, a layered body composed of (the transparent plate 1)-(the solar cell element 3)-(the sealant sheet)-(the back surface protection sheet 2) is subjected to vacuum-pressure molding with application of heat. The sealant sheet is thermally cured to be the sealant 4 sealing the surrounding of the solar cell element 3 in a state of being contact with the transparent plate 1.

The thickness of the sealant 4 is preferably set in a range from 30 µm to 400 µm depending on its application. In order to form the sealant 4 with the aforementioned film thickness, the thicknesses of the coating film and the sealant sheet are appropriately adjusted in a range from 30 µm to 400 µm.

The coating film constituting the sealant sheet for use in the present invention has a pencil hardness (B) after being thermally cured of 4B or higher. In addition, the coating film has a characteristic that a hardness ratio (B/A) of the hardness (B) after being thermally cured relative to a hardness (A) before being heated is 1.1 or higher.

An inorganic glass plate is typically used as the transparent plate 1. An acrylic organic glass and any transparent resin sheet may also be used as the transparent plate 1.

As the back surface protection sheet 2, a resin film produced by extrusion of any one of or a mixture of resins each having an insulation property may be used. Examples of the resins may include PE (polyethylene), PP (polypropylene), PET (polyethylene terephthalate), PEN (polyethylene naphthalate), PBT (polybutylene terephthalate), LCP (liquid crystal polymer), PVF (polyvinyl fluoride), PPS (polyphenylenesulfide), polyamide (nylon 6, and nylon 66), and PC (polycarbonate) resins. Particularly, a PET resin film is preferable in terms of cost and properties.

### (Water-soluble thermosetting resin-dispersed paint)

The paint for forming the aforementioned coating film is a water-soluble thermosetting resin-dispersed paint. The paint contains a resin having a quaternized ammonium group that is used as a dispersant. The resin is the one obtained by addition of a tertiary amine compound and an organic acid to a resin having an epoxy group. This dispersant is emulsion-polymerized with a monomer mixture containing an α,β-ethylenically unsaturated monomer having an alkoxysilyl group, so that water-soluble thermosetting resin particles is obtained. An alkoxysilane paint is prepared such that the paint contains from 3 to 20% by weight of the resulting water-soluble thermosetting resin particles as a solid content. The resulting paint may be used as the water-soluble thermosetting resin-dispersed paint in the present invention.

The thick coating film formed with the paint is once plasticized with the heat in vacuum-pressure molding in the assembling process of the solar cell module, to be tightly bonded to the solar cell element. The plasticized coating film is thereafter cured so as to seal the solar cell element. This process does not involve such a phenomenon that the coating film in a plasticized state overflows to the periphery of the solar cell module, and sticks to the assembly apparatus to cause contamination. Employment of such a coating film enables sealing of the solar cell element with high accuracy. As a result, a high quality solar cell module can be obtained.

The solid content weight ratio of the resin having the ammonium group (dispersant) relative to the monomer mixture may be from 5/95 to 20/80. The ratio of the α,β-ethylenically unsaturated monomer having the alkoxysilyl group in the monomer mixture may be from 5 to 35% by weight. A weight average molecular weight of the water-soluble thermosetting resin may be from 6000 to 12000. A glass-transition temperature of the monomer mixture may be from 50 to 100°C. The water-soluble thermosetting resin may further include an alcohol having 1 to 18 carbon atoms. The molar quantity content of the alcohol may be from 2 to 5 times larger than that of the α,β-ethylenically unsaturated monomer having the alkoxysilyl group.

In a manufacturing method of the water-soluble thermosetting resin-dispersed paint, the resin having the ammonium group is used as the dispersant, wherein the resin is a quaternized ammonium resin obtained by adding the tertiary amine compound and the organic acid to the resin having the epoxy group. With the dispersant, the monomer mixture containing the α,β-ethylenically unsaturated monomer having the alkoxysilyl group is emulsion-polymerized.

It is preferable that the paint contains from 3 to 20% by weight of the water-soluble thermosetting resin particles as the resin solid content. As a binder component, the paint may contain an epoxy resin and/or an acrylic resin having an amine-modified epoxy group. The paint may also contain the resin having the ammonium group as the binder component.

The water-soluble thermosetting resin before being heated is in a non-crosslinking state. Thus, when the coating film formed by the application on the transparent plate 1 or/and the back surface protection sheet 2 is heated, the resin particles constituting the coating film start melting and simultaneously water attached to the surfaces of the resin particles becomes moisture and diffuses in the region between the particles. Subsequently, the moisture reacts with the alkoxyl groups constituting the resin particles to form alkoxysilyl groups. Thereafter, condensation between the alkoxysilyl groups proceeds. As a result, the hardness of the coating film increases in a uniform manner in the film thickness direction. Consequently, the coating film is homogeneously cured by the homogeneous moisture. The solar cell element is sealed with the sealant obtained by homogeneous curing of the coating film, to thereby achieve very high airtightness.
In addition, when the coating film is used, no insufficiency in curing of the coating film occurs in the process in which the coating film is once plasticized and then cured with the heat in vacuum-pressure molding in the assembling process of the solar cell module. Consequently, the use of the coating film can prevent a phenomenon which occurs when the related-art sealant sheet is used, in which an adhesive resin melts and overflows due to insufficient curing of the sheet, and the adhesive resin in the plasticized state sticks to an assembly board surface of the molding apparatus to cause contamination.

By setting a value of a solubility parameter of the monomer mixture serving as a raw material of the paint in a certain range, the resin particles can be dispersed in a uniform state in the coating film. By setting the glass-transition temperature of the monomer mixture at a high temperature, stability of the monomer mixture in a paint component that will serve as the binder can be enhanced.
By setting the molecular weight of the resin particle to a lower value, flowability of the paint can be enhanced.

It is preferable that the resin having the ammonium group has from 2 to 15 ammonium groups per molecule. When the number of ammonium groups is greater than 15 per molecule, a water-resistant property may lower, whereas, when the number of ammonium groups is smaller than 2 per molecule, it is difficult to obtain the desired water-soluble thermosetting resin-dispersed paint.

The resin having the ammonium group for use is a quaternized resin obtained by adding the tertiary amine compound and the organic acid to the resin having the epoxy group. When a resin obtained by quaternizing a resin having a tertiary amino group with the organic acid is used, the water-soluble thermosetting resin-dispersed paint obtained using such a resin may have a problem in storage stability.

Examples of the resin having an epoxy group may include an epoxy resin and an acrylic resin. The epoxy resin is not limited to a specific type, and general examples thereof may include a polyphenol polyglycidyl ether type epoxy resin that is a reaction product of a polycyclicphenol compound with epichlorohydrin, wherein the polycyclicphenol compound may be bisphenol-A, bisphenol-F, bisphenol-S, phenolnovolack, and cresolnovolack. In addition, it is also possible to use a resin obtained by chain extension of the epoxy resin exemplified in the above with, e.g., bifunctional polyester polyol, polyether polyol, bisphenols, and a dibasic carboxylic acid. When the aforementioned epoxy resin is used as the resin having the epoxy group, it is preferable that the epoxy equivalent of the epoxy resin is from 600 to 1200.

On the other hand, the acrylic resin for use may be an acrylic resin having an epoxy group that is obtained by copolymerizing the α,β-ethylenically unsaturated monomer having an epoxy group, such as glycidil (meth)acrylate, with another α,β-ethylenically unsaturated monomer. In the quaternization, the epoxy group is ring-opened by the tertiary amine to form the ammonium group. The amount of the α,β-ethylenically unsaturated monomer having the epoxy group may thus be determined based on the aforementioned preferable number of ammonium groups. The other α,β-ethylenically unsaturated monomer for use may be an α,β-ethylenically unsaturated monomer that does not react with the epoxy group, among typical α,β-ethylenically unsaturated monomers examples of which will be enumerated in the description of manufacture of the water-soluble thermosetting resin particles.

The solubility parameter of the monomer for copolymerization for obtaining the acrylic resin having the epoxy group is preferably six or more. The monomer having the solubility parameter of less than six may cause a problem of adhesion insufficiency between the resin and the substrate (the transparent plate 1 and/or the back surface protection sheet 2).

The solubility parameter is referred to by a person skilled in the art as solubility parameter (sometimes also abbreviated as SP). The solubility parameter is a index of hydrophilicity or hydrophobicity of a resin, and also an important index to determine compatibility between resins. The solubility parameter is numerically quantified based on a turbidity measurement method such as the method described in the following literature. Reference literature: K. W. Suh, D.H. Clarke, J. Polymer. Sci., A-1,5,1671 (1967).

The acrylic resin having an epoxy group may be obtained by a typical method, in which the aforementioned monomers are solution-polymerized using a well-known initiator. A number average molecular weight of the acrylic resin having an epoxy group obtained in this manner is preferably from 5000 to 20000. When the number average molecular weight is more than 20000, viscosity of the resin increases to excessively high level that is unsuitable as an emulsifier whereas, when the number average molecular weight is less than 5000, it is difficult to obtain desired water-based resin particles.

The quaternization may be achieved by preliminarily mixing the tertiary amine compound and the organic acid, and then adding the mixture to the resin having an epoxy group as a quaternization agent.

Examples of the tertiary amine compound for incorporating the ammonium group in the resin may include trimethylamine, triethylamine, tributylamine, trioctylamine, dimethylethanolamine, and methyldiethanolamine. The amount of the tertiary amine compound may be determined depending on the amount of the ammonium group to be incorporated.

Examples of the organic acid may include formic acid, acetic acid, lactic acid, propionic acid, boric acid, butyric acid, dimethylolpropionic acid, hydrochloric acid, sulfuric acid, phosphoric acid, N-acetylglycine, and N-acetyl-β-alanine. Among these examples, lactic acid, acetic acid, and dimethylolpropionic acid are preferable in terms of stability in the emulsification process.

In the quaternization, the molar ratio of the epoxy group included in the acrylic resin having an epoxy group, the tertiary amine compound, and the organic acid are preferably from 1/1/1 to 1/1/2. The quaternization reaction is generally performed over 2 to 10 hours. If needed, the materials under the reaction may be heated at from 60 to 100°C.

Examples of the α,β-ethylenically unsaturated monomer having the alkoxysilyl group may include γ-methacryloxypropyltrimethoxysilane, γ-acryloxypropylmethyldimethoxysilane, γ-methacryloxypropylmethyldimethoxysilane, γ-acryloxypropyldimethylmethoxysilane, γ-methacryloxypropyldimethylmethoxysilane, γ-acryloxypropyltriethoxysilane, γ-methacryloxypropyltriethoxysilane, γ-acryloxypropylmethyldiethoxysilane, γ-methacryloxypropyl-methyldiethoxysilane, γ-acryloxypropyldimethylethoxysilane, γ-methacryloxypropyldimethylethoxysilane, vinyltrimethoxysilane, vinylmethyldimethoxysilane, vinyltriethoxysilane, vinylmethyldiethoxysilane, trimethoxysilylstyrene, dimethoxymethylsilylstyrene, triethoxysilylstyrene, and diethoxymethylsilylstyrene. Among these compounds, γ-methacryloxypropyltrimethoxysilane, γ-methaoryloxypropyltriethoxysilane, γ-methacryloxypropylmethyldimethoxysilane, and γ-methacryloxypropylmethyldiethoxysilane are more preferable because they are well polymerized with other α,β-ethylenically unsaturated monomer, and easily industrially available.

The monomer mixture contains a general α,β-ethylenically unsaturated monomer, in addition to the a,β-ethylenically unsaturated monomer having the alkoxysilyl group. Examples of the general α,β-ethylenically unsaturated monomer may include an α,β-ethylenically unsaturated monomer having a hydroxyl group, such as hydroxyethyl acrylate, hydroxyethyl methacrylate, hydroxypropyl acrylate, hydroxypropyl methacrylate, hydroxybutyl acrylate, hydroxybutyl methacrylate, allyl alcohol, methacryl alcohol, and a hydroxyethyl acrylate or hydroxyethyl methacrylate adduct of ε-caprolactone.

On the other hand, examples of the α,β ethylenically unsaturated monomer having no reactive functional group may include acrylic ester or methacrylic ester (e.g., methyl acrylate, methyl methacrylate, ethyl acrylate, ethyl methacrylate, n-propyl acrylate, n-propyl methacrylate, isopropyl acrylate, isopropyl methacrylate, n-butyl acrylate, n-butyl methacrylate, isobutyl acrylate, isobutyl methacrylate, t-butyl acrylate, t-butyl methacrylate, 2-ethylhexyl acrylate, 2-ethylhexyl methacrylate, lauryl methacrylate, phenyl acrylate, isobornyl acrylate, isobornyl methacrylate, cyclohexyl methacrylate, t-butylcyclohexyl acrylate, t-butylcyclohexyl methacrylate, dicyclopentadienyl acrylate, dicyclopentadienyl methacrylate, dihydrodicyclopentadienyl acrylate, and dihydrodicyclopentadienyl methacrylate), polymerizable aromatic compounds (e.g., styrene, α-methylstyrene, vinyl ketone, t-butylstyrene, para-chlorostyrene, and vinylnaphthalene), polymerizable nitrile (e.g., acrylonitrile, and methacrylonitrile), α-olefine (e.g., ethylene, and propylene), vinyl ester (e.g., vinyl acetate, and vinyl propionate), diene (e.g., butadiene and isoprene), a polymerizable aromatic compound, polymerizable nitrile, α-olefine, vinyl ester, and diene.

The ratio of the α,β-ethylenically unsaturated monomer having the alkoxysilyl group in the monomer mixture may be 5 to 35% by weight. When the ratio is less than 5% by weight, overflow prevention may not become sufficient whereas, when the ratio is more than 35% by weight, storage stability may become insufficient.

It is preferable that the glass-transition temperature of the monomer mixture is from 50 to 100°C. When the glass-transition temperature is lower than 50°C, storage stability may become insufficient whereas, when the glass-transition temperature is higher than 100°C, overflow prevention may become insufficient. Preferable lower limit is 60°C whereas preferable upper limit is 95°C.

It is preferable that the solubility parameter of the monomer mixture is from 9 to 12. When the solubility parameter is less than 9, adhesion with the resin film may become insufficient whereas, when the solubility parameter is more than 12, an outer appearance and a rust prevention property of the coating film formed with an alkoxysilane adhesive paint in which the resin is used tend to lower.

The monomer mixture may contain an alcohol having 4 to 18 carbon atoms. Containing an alcohol having 6 to 18 carbon atoms, the monomer mixture can improve storage stability of the water-soluble thermosetting resin-dispersed paint of the present invention.

Examples of the alcohol having 6 to 18 carbon atoms may include straight chain aliphatic alcohols (e.g., hexyl alcohol, octyl alcohol, lauryl alcohol, and stearyl alcohol), branched aliphatic alcohols (e.g., 2-ethylhexyl alcohol, and cyclohexyl alcohol), polyethylene glycol ethers (e.g., ethylene glycol monoalkyl ethers, diethylene glycol monoalkyl ethers, triethylene glycol monoalkyl ethers, and polyethylene glycol phenyl ether), polypropylene glycol ethers (e.g., propylene glycol monoalkyl ethers, dipropylene glycol monoalkyl ethers, tripropylene glycol monoalkyl ethers, and polypropylene glycol phenyl ether), and aromatic alcohols (e.g., phenol, and cresol).

When the monomer mixture contains an alcohol having 6 to 18 carbon atoms, the molar content of the alcohol may be set from 2 to 5 times that of the α,β-ethylenically unsaturated monomer having the alkoxysilyl group. When the molar content is less than 2 times, it may be difficult to improve storage stability whereas, when the molar content is more than 5 times, overflow and sticking prevention may become insufficient. The water-soluble thermosetting resin-dispersed paint thus obtained for use in the present invention substantially contains a predetermined amount of the alcohol having 6 to 18 carbon atoms. An alcohol that is not contained in the monomer mixture, such as an alcohol used as a solvent in manufacturing the acrylic resin having the ammonium group, is not included as the alcohol having 6 to 18 carbon atoms.

The emulsion-polymerization for obtaining the water-soluble thermosetting resin-dispersed paint may be performed by a well-known method. Specifically, the polymerization may be performed by adding the resin having the ammonium group as a dispersant to an aqueous vehicle containing water and, if necessary, an organic solvent such as alcohol, and then adding dropwise the monomer mixture and a polymerization initiator into the aqueous vehicle while the aqueous vehicle is heated and stirred. The dropwise addition of the monomer mixture may be performed by adding dropwise a monomer mixture that has been preliminarily emulsified using a dispersant and water.

Preferably, the emulsion-polymerization may be performed by the following method. The aforementioned dispersant is dissolved in the aqueous vehicle. Then, the initiator is added dropwise while the aqueous vesicle is heated and stirred. Then, part of the monomer mixture is added dropwise. Then, remaining monomer mixture that has been preliminarily emulsified by using the dispersant and water is added dropwise. This method can reduce deviation of the particle size of the resin from a desired particle size. As a result, preferable water-soluble thermosetting resin particles can be formed.

Examples of the preferably used polymerization initiator may include: azo oil compounds (e.g., azobisisobutyronitrile, 2,2'-azobis(2-methylbutyronitrile), 2,2'-azobis(2-(2-imidazolin-2-ylypropane), and 2,2'-azobis(2,4-dimethylvaleronitrile); aqueous compounds (e.g., anionic compounds such as 4,4'-azobis(4-cyanovaleric acid), 2,2-azobis(N-(2-carbaxyethyl)-2-methylpropionamidine), and cationic compounds such as 2,2'-azobis(2-methylpropionamidine); redox oil peroxides (e, g., benzoyl peroxide, para-chlorobenzoyl peroxide, lauroyl peroxide, and t-butyl perbenzoate); and aqueous peroxides (e.g., potassium persulfate, and ammonium persulfate).

In addition to the aforementioned dispersant, dispersants that are usually used by persons skilled in the art and reactive emulsifying agents may be used together. Examples thereof may include Antox MS-60 (a trade name of a product manufactured by Nippon Nyukazai Co., Ltd.), Eleminol JS-2 (a trade name of a product manufactured by Sanyo Chemical Industries, Ltd.), Adekalia Soap NE-20 (a trade name of a product manufacture by Asahi Denka Co., Ltd.), and Aquaron HS-10 (a trade name of a product manufactured by Daiichi Kogyo Seiyaku Co., Ltd).

The blend ratio of the resin having the ammonium group used as the dispersant relative to the monomer mixture is preferably adjusted in a range from 5/95 to 20/80 by the solid content weight ratio. When the blend solid content ratio is less than 5/95, the monomer particles in the dispersed solution are cohered to form aggregates, which lead to deterioration in smoothness of the coating film and defect in solar cell element sealing. When the blend solid content ratio is more than 20/80, the sealant tends to overflow.

If necessary, it is allowable to use a chain transfer agent such as mercaptan such as laurylmercaptan, and α-methylstyrene dimer for adjusting molecular weight of the resin.

The reaction temperature is determined by the initiator. For example, the reaction temperature is preferably from 60 to 90°C when an azo-based initiator is used. When a redox-based initiator is used, the reaction temperature is preferably from 30 to 70°C. Generally, the reaction duration is from 1 to 8 hours. The amount of the initiator relative to the total amount of the (α,β-ethylenically unsaturated monomer mixture is generally from 0.1 to 5% by weight, and preferably from 0.2 to 2% by weight.

It is preferable that the average particle size of dispersed resin particles in the water-soluble thermosetting resin-dispersed paint thus obtained is in a range from 0.05 to 0.30 µm. When the particle size is smaller than 0.05 µm, workability improvement effect may become small whereas, when the particle size is larger than 0.30 µm, an outer appearance of the resulting coating film may deteriorate. The particle size may be controlled by, e.g., adjusting the composition of the monomer mixture and emulsion polymerization conditions.

It is preferable that the weight average molecular weight of the water-soluble thermosetting resin is from 6000 to 12000. When the weight average molecular weight is less than 6000, the sealant may extensively overflow whereas, when the weight average molecular weight is more than 12000, the smoothness of the coating film may lower.

The water-soluble thermosetting resin-dispersed paint for use in the present invention is an alkoxysilane paint containing from 3 to 20% by weight of the water-soluble thermosetting resin as the resin solid content. When the resin solid content is less than 3% by weight, the effect of the sealant overflow prevention may not be obtained whereas, when the resin solid content is more than 20% by weight, the smoothness of the coating film may end up in being damaged. In the water-soluble thermosetting resin-dispersed paint, the binder component is preferably the epoxy resin and/or the acrylic resin obtained by the amine-moditication of .the epoxy group. The binder component may contain the resin having the ammonium group.

The water-soluble thermosetting resin-dispersed paint for use in the present invention may be obtained by adding a predetermined amount of the water-soluble thermosetting resin to a usual water-based paint emulsion composition. Examples of the emulsion composition of the water-based alkoxysilane paint may include the emulsion composition containing the epoxy resin and/or the acrylic resin having the amine-modified epoxy group as the binder resin, and a block isocyanate as a hardener.

### Examples

Manufacturing Examples for obtaining materials for use in Examples of the present invention will be described hereinbelow. In the following Manufacturing Examples and Examples, "part", "%", and ratio are based on weight.

### (Manufacturing Example 1) Manufacture of acrylic resin having ammonium group

In a reaction container, 120 parts of butyl cellosolve was placed, and heated at 120°C and stirred. An initiator solution and monomers are simultaneously added dropwise thereinto over 3 hours, wherein the initiator solution is a mixture of 2 parts of t-butylperoxy-2-ethylhexanoate and 10 parts of butyl cellosolve, and wherein the monomers are composed of 19 parts of glycidyl methacrylate, 60 parts of 2-ethylhexyl methacrylate, 20 parts of 2-hydroxyethyl methacrylate, and 1 part of n-butyl methacrylate, and has a solubility parameter of 10.1. After aging for 30 minutes, a solution that is a mixture of 0.5 parts of t-butylperoxy-2-ethylhexanoate and 5 parts of butyl cellosolve was added dropwise over 30 minutes into the reaction mixture. After another aging for 2 hours, the solution was cooled down.

The acrylic resin having epoxy groups thus obtained had a number average molecular weight of 8500 and a weight average molecular weight of 17900, which were measured by a GPC using polystyrene standards. Then, 7 parts of dimethylaminoethanol and 15 parts of a 50% lactic acid aqueous solution were added to the acrylic resin, and the mixture was heated at 80°C, to perform quaternization. Heating was ceased at the time when an acid number was equal to or smaller than one, and an increase in viscosity plateaued. In this manner, an acrylic resin having ammonium groups was obtained. The number of ammonium groups per molecule of the acrylic resin having ammonium groups was 8.2.

### (Manufacturing Example 2) Manufacture of substrate resin

In a reaction container, 54.0 parts of 2,4-/2,6-tolylene diisocyanate (weight ratio = 8/2), 136 parts of methyl isobutyl ketone (referred to hereinbelow as MIBK), and 0.5 parts of dibutyltin dilaurate were placed. Then, 10.9 parts of methanol was added thereto at a room temperature, whereby the temperature of the system increased to 60°C due to exotherm. After continuing the reaction for 30 minutes, 54 parts of ethylene glycol mono-2-ethylhexyl ether was added dropwise over 1 hour. The reaction was performed mainly in a temperature range from 60 to 65°C, and continued while an IR spectrum thereof was measured until the isocyanate group disappeared.

Then, 285 parts of an epoxy resin that had been synthesized from bisphenol F and epichlorohydrin and had an epoxy equivalent of 950 was added. The temperature was increased to 12.5°C. Thereafter, 0.62 parts of benzildimethylamine was added. The reaction continued while distilling away by-product methanol using a decanter, until the epoxy equivalent reached 1120. Then, the reaction mixture was cooled down. Thereafter, 29.1 parts of diethanolamine, 21.5 parts of methylethanolamine, and 32.9 parts of ketimined product of aminoethylethanolamine (79% by weight MIBK solution) were added, and the reaction continued for 2 hours at 110°C. Then, the reacted product was diluted with MIBK until a nonvolatile content was 80%, to obtain a substrate resin having an oxazolidone ring.

### (Manufacturing Example 3) Manufacture of block isocyanate hardener

In a reaction container, 222 parts of 3-isocyanatomethyl-3,5,5-trimethylcyclohexylisocyanate, and 55.5 parts of MIBK were placed, and heated at 70°C. After the contents were uniformly dissolved, 17.4 parts of methyl ethyl ketoxime was added dropwise over 2 hours. After the completion of the dropwise addition, the reaction continued while temperature was kept at 70°C until confirming disappearance of the isocyanate group by IR analysis, to obtain a block isocyanate hardener.

### (Manufacturing Example 4) Manufacture of water-soluble thermosetting resin dispersion liquid AB1

### (Resin dispersion liquid A1)

In a reaction container, 20 parts of the acrylic resin having ammonium groups manufactured in Manufacturing Example 1, and 270 parts of deionized water were placed, and heated at 75°C and stirred. Into this resin dispersion liquid, a neutral aqueous solution of 1.5 parts of 2,2'-azobis(2-(2-imidazolin-2-yl)propane) neutralized by an acetic acid with a neutralization rate of 100% was added dropwise over 5 minutes. After aging of the resulting mixed resin dispersion liquid for 5 minutes, 30 parts of methyl methacrylate was added dropwise over 5 minutes. The mixed resin dispersion liquid was further subjected to aging for minutes. The mixed resin dispersion liquid after the aging is designated as a resin dispersion liquid A1.

### (Resin dispersion liquid B1)

70 parts of the acrylic resin having ammonium groups manufactured in Manufacturing Example 1 and 250 parts of deionized water were mixed to obtain a resin dispersion liquid Bla. Apart from the resin dispersion liquid Bla, 170 parts of methyl methacrylate, 40 parts of styrene, 30 parts of n-butyl methacrylate, 30 parts of γ-methacryloxypropyltriethoxysilane, and 1 part of laurylmercaptan are mixed and stirred, to obtain a mixed resin dispersion liquid (a monomer mixture containing the α,β-ethylenically unsaturated monomer having the alkoxysilyl group) B1b. The mixed resin dispersion liquid B1b was added to the resin dispersion liquid B1a, and then they were stirred, to obtain a pre-emulsion. The pre-emulsion is designated as a resin dispersion liquid B1.

The resin dispersion liquid B1 was added dropwise over 40 minutes into the resin dispersion liquid A1. After aging of the resulting mixed resin dispersion liquid for 60 minutes, the mixed resin dispersion liquid was cooled down, to obtain a water-based resin particle dispersion liquid AB1. The resulting water-soluble thermosetting resin dispersion liquid AB1 had a nonvolatile content of 38%, a pH of 5.0, and an average particle size of 90 nm. The average particle size was measured by a laser light scattering method.

### (Manufacturing Example 5) Manufacture of water-soluble thermosetting resin dispersion liquid 4B2

### (Resin dispersion liquid A2)

In a reaction container, 20 parts of the acrylic resin having ammonium groups manufactured in Manufacturing Example 1, and 270 parts of deionized water were placed, heated at 75°C and stirred. Into the resin dispersion liquid, a neutral aqueous solution of 1 part of 2,2'-azobis(2-(2-imidazolin-2-yl)propane) neutralized by an acetic acid with a neutralization rate of 100% was added dropwise over 5 minutes. After aging of the resulting mixed resin dispersion liquid for 5 minutes, 30 parts of methyl methacrylate was added dropwise over 5 minutes. The mixed resin dispersion liquid was further subjected to aging for 5 minutes. The mixed resin dispersion liquid after the aging is designated as a resin dispersion liquid A2.

### (Resin dispersion liquid B2)

70 parts of the acrylic resin having ammonium groups manufactured in Manufacturing Example 1 and 270 parts of deionized water were mixed to obtain a resin dispersion liquid B2a. Apart from the resin dispersion liquid B2a, 150 parts of methyl methacrylate, 35 parts of styrene, 25 parts of n-butyl methacrylate, 60 parts of γ-methacryloxypropyltriethoxysilane, and 1 part of iaurylmercaptan were mixed and stirred, to obtain a mixed resin dispersion liquid (a mixture containing the α,β-ethylenically unsaturated monomer having the alkoxysilyl group) B2b. The mixed resin dispersion liquid B2b was added to the resin dispersion liquid B2a, and then they were stirred, to obtain a pre-emulsion. The pre-emulsion is designated as a resin dispersion liquid B2.

The resin dispersion liquid B2 was added dropwise over 40 minutes into the resin dispersion liquid A2. After aging of the resulting mixed resin dispersion liquid for 60 minutes, the mixed resin dispersion liquid was cooled down, to obtain a water-soluble thermosetting resin dispersion liquid AB2. The resulting water-based resin particle dispersion liquid AB2 had a nonvolatile content of 37%, a pH of 4.7, and an average particle size of 100 nm. The average particle size was measured by the laser light scattering method.

### (Manufacturing Example 6) Manufacture of water-soluble thermosetting resin dispersion liquid AB3

A water-soluble thermosetting resin particle dispersion liquid AB3 was obtained in the same manner as in Manufacturing Example 4 except that the composition of the mixed resin dispersion liquid (the mixture containing the α,β-ethylenically unsaturated monomer having the alkoxysilyl group) B1b was changed. The changed composition was composed of 150 parts of methyl methacrylate, 35 parts of styrene, 55 parts of n-butyl acrylate, 30 parts of γ-methacryloxypropyltriethoxysilane, and 1 part of laurylmercaptan. The resulting water-based resin particle dispersion liquid AB3 had a nonvolatile content of 38%, a pH of 5.0, and an average particle size of 90 nm. The average particle size was measured by the laser light scattering method.

### (Manufacturing Example 7) Manufacture of water-soluble thermosetting resin dispersion liquid AB4

A water-based resin particle dispersion liquid AB4 was obtained in the same manner as in Manufacturing Example 4 except that the composition of the mixed resin dispersion liquid (the mixture containing the α,β-ethylenically unsaturated monomer having the alkoxysilyl group) B1b was changed. The changed composition was composed of 150 parts of methyl methacrylate, 35 parts of styrene, 55 parts of n-butyl methacrylate, 30 parts of γ-methacryloxypropyltriethoxysilane, 1 part of laurylmercaptan, and 40 parts of lauryl alcohol. The resulting water-soluble thermosetting resin dispersion liquid AB4 had a nonvolatile content of 38%, a pH of 5.0, and an average particle size of 90 nm. The average particle size was measured by a laser light scattering method.

### (Manufacturing Example 8) Manufacture of comparative water-soluble thermosetting resin dispersion liquid C1

A comparative water-soluble thermosetting resin particle dispersion liquid C1 was obtained in the same manner as in Manufacturing Example 4 except that the composition of the mixed resin dispersion liquid (the mixture containing the α,β-ethylenically unsaturated monomer having the alkoxysilyl group) B1b was changed to a composition containing no α,β-ethylenically unsaturated monomer having the alkoxysilyl group. The changed composition was composed of 160 parts of methyl methacrylate, 45 parts of styrene, 65 parts of n-butyl methacrylate, and 1 part of laurylmercaptan. The resulting comparative water-soluble thermosetting resin particle dispersion liquid C1 had a nonvolatile content of 38%, a pH of 5.0, and an average particle size of 90 nm. The average particle size was measured by a laser light scattering method.

### (Manufacturing Example 9) Manufacture of comparative water-soluble thermosetting resin dispersion liquid C2

A comparative water-soluble thermosetting resin particle dispersion liquid C2 was obtained in the same manner as in Manufacturing Example 5 except that the composition of the mixed resin dispersion liquid (the mixture containing the α,β-ethylenically unsaturated monomer having the alkoxysilyl group) B2b was changed. The changed composition was composed of 165 parts of methyl methacrylate, 30 parts of styrene, 25 parts of n-butyl methacrylate, 30 parts of γ-methacryloxypropyltriethoxysilane, and 25 parts of neopentyl glycol dimethacrylate. The resulting comparative water-soluble thermosetting resin particle dispersion liquid C2 had a nonvolatile content of 38%, a pH of 5.0, and an average particle size of 90 nm. The average particle size was measured by a laser light scattering method.

### (Example 1) Manufacture of water-soluble thermosetting resin-dispersed paint P1

The substrate resin obtained in Manufacturing Example 2 and the block isocyanate hardener obtained in Manufacturing Example 3 were uniformly mixed at the solid content blend ratio of 75:25, and thereafter a solvent was added to the mixture by an amount of 3% relative to the solid content. In addition, a glacial acetic acid was added so as to neutralize the mixture to have a neutralization ratio of 43%. Then, ion-exchanged water was added so as to gradually dilute the mixture. Then, MIBK was removed under reduced pressure so that the solid content was 36%. As a result, a main emulsion was obtained.

1500 parts of this main emulsion, 9.0 parts of dibutyltin oxide and the water-soluble thermosetting resin particle dispersion liquid AB1 obtained in Manufacturing Example 4 in an amount whereby the solid content of the dispersion liquid accounts for 10% of the resin solid content of the paint were mixed with 2000 parts of deionized water, to prepare an alkoxysilane paint containing the water-soluble thermosetting resin particles (water-soluble thermosetting resin-dispersed paint) P1.

The paint P1 was applied on both surfaces of PET (having a thickness of 50 µm) with a thickness of 100 µm. The hardness of the coating film was measured before and after being heated at 150°C for 5 minutes. The hardness (A) before being heated was 50 (JIS hardness A), whereas the hardness (B) after being heated was 88 (hardness ratio (B/A) = 1.8). The gas barrier property (JIS Z0208 cup method (40°C x 90% RH)) after being cured was 0.1 g/m²•24 hrs.

### (Examples 2 to 4) Manufacture of water-soluble thermosetting resin-dispersed paints P2, P3, and P4

Alkoxysilane paint compositions containing water-soluble thermosetting resin particles (water-soluble thermosetting resin-dispersed paints) P2, P3, and P4 were prepared in the same manner as Example 1 except that the water soluble thermosetting resin particle-dispersed liquids were changed to the dispersed liquids AB2, AB3, and AB4, respectively, obtained by Manufacturing Examples 5 to 7, respectively.

Each of the paints P2, P3, and P4 was applied on both surfaces of a PET film (having a thickness of 50 µm) with a thickness of 100 µm. The hardness of each coating film was measured before and after being heated at 150°C for 5 minutes. The hardness (A) before being heated was 40, 45, and 48 (JIS hardness A), respectively, whereas the hardness (B) after being heated was 66, 59, and 58 (hardness ratios (B/A) are 1.5, 1.3, and 1.2), respectively. The gas barrier property (JIS Z0208 cup method (40°C × 90% RH)) after being cured was 0.2, 0.4, and 0.8 g/m²•24 hrs, respectively.

### (Comparative Examples 1 and 2) Manufacture of comparative paint compositions Pc1 and Pc2

Two kinds of comparative paint compositions Pc1 and Pc2 were prepared in the same manner as Example 1 except that the water-soluble thermosetting resin particle dispersion liquid AB1 was changed to the comparative water-soluble thermosetting resin particle dispersion liquid C1 containing no alkoxysilyl group obtained in Manufacturing Example 8, and to the comparative water-soluble thermosetting resin particle dispersion liquid C2 obtained in Manufacturing Example 9, respectively.

Each of the two kinds of paint compositions Pc1 and Pc2 was applied on both surfaces of PET (having a thickness of 50 µm) with a thickness of 100 µm. The hardness of each coating film was measured before and after being heated at 150°C for 5 minutes. The hardness (A) before being heated was 40 and 47 (JIS hardness A), respectively, whereas the hardness (B) after being heated was 38 and 43 (hardness ratios (B/A) are 0.1 and 0.9), respectively. The gas barrier property (JIS Z0208 cup method (40°C x 90% PH)) after being cured was 23 and 18 g/m²•24 hrs, respectively.

### (Comparative Example 3)

Properties of the related-art sealant sheet were examined in the following manner. The related-art sealant sheet was a layered sheet prepared with an extruder and composed of a core material of an ethylene resin and a graft polymer or a copolymer of alkoxysilane.

0.5 parts by weight of a hindered amine light stabilizer and 0.1 parts by weight of a phenol antioxidant were added to a silane modified ethylene-ethyl acrylate copolymer in which 0.8% by weight of alkoxysilane was graft-polymerized at 83°C, which is the melting point of the silane modified ethylene-ethyl acrylate copolymer, to prepare a copolymer composition. The copolymer composition was extruded by an extruding method at 150°C to form a sheet having a thickness of 100 µm. From the resulting sheet, two sheets were cut out. The two cut sheets were laminated on both surfaces of PET (having a thickness of 50 µm) by hot pressing under the conditions of 150°C for 5 minutes, so that a layered body was formed. The gas barrier property (JIS Z0208 cup method (40°C x 90% PH)) of the layered body was measured, and the value was 17 g/m²•24 hrs.

### (Evaluation)

A solar cell element was sealed with the paint compositions obtained in Examples 1 to 4 and Comparative Examples 1 to 3, and sealing properties were evaluated. An aluminum plate having a thickness of 0.3 mm was used as a substitute for the solar cell element. A mock solar cell module for evaluation was assembled in the following manner.

The layer structure of the mock solar cell module was as follows: an aluminum plate (substitute element) was placed on a sealant layer of a back sheet (back surface protection sheet integrated with a sealant); a sealant sheet was layered thereon so as to cover the aluminum plate; and lastly, a light receiving side transparent plate was layered.

A float glass having a thickness of 3 mm was prepared as the light receiving side transparent plate. As the back surface protection sheet (back sheet), a back surface protection sheet integrated with a sealant (sealant-integrated substrate) was prepared in which a sealant layer having a thickness of 0.3 mm was layered on a PET film having a thickness of 125 µm. The sealant layers of the back sheets were composed of each of the dried coating films of the paint compositions obtained in Examples 1 to 4 and comparative Examples 1 to 3. As the sealant sheet, the dried coating films (having a thickness of 0.3 mm) of the paint compositions obtained in Examples 1. to 4 and Comparative Examples 1 to 3 were prepared.

The layered bodies had the sealant sheets and the sealant layers of the back sheets that were composed of each of the dried coating films of the paint compositions obtained in Examples 1 to 4 and Comparative Examples 1 to 3. Each of the layered bodies was molded by vacuum heat press at 130°C for 20 minutes, to obtain mock solar cell modules.

Overflow contamination levels on the forming apparatus caused by the sealants during fixed molding of the mock modules were observed (evaluation (i)). The resulting mock solar cell module samples were subjected to the following various endurance tests and evaluations.
(1) Left stand for 2000 hours with a sunshine weather meter.
(2) Left stand for 2000 hours at 85°C and 85% RH (in accordance with JIS C8917).
(3) Left stand for 200 hours in a 10% sodium hydroxide aqueous solution at 23°C (in accordance with JIS K7114) .
After each of the processing (1), (2), and (3), evaluation was performed by visual observation by the comparison with the samples before processing. The evaluation was performed as to presence or absence of yellowing, cracks, and bubbles in the sealant (evaluation (ii)), presence or absence of peeling of the sealant off the glass plate and the back surface protection sheet (back sheet) (evaluation (iii)), and presence and absence of corrosion of the aluminum plate (evaluation (iv)). Thus the evaluation items were of three types each consists of 6 items, i.e., 18 items in total. Each evaluation was determined with a three-stage rating that are excellent, good, and poor that are detailed in the following. The results are shown in (Table 1) and (Table 2).

Excellent: in comparison of 18 items, the number of items in which a slight change was observed was 10 or less, and no significant change was observed.
Good: in comparison of 18 items, the number of items in which a slight change was observed was 11 or more, although no significant change was observed.
Poor: in comparison of 18 items, the number of items in which a significant change was observed was one or more.

**(Table 1)**

| | | | | Example 1 | Example 2 | Example 3 | Example 4 |
|---|---|---|---|---|---|---|---|
| (i) Sealant overflow and contamination | | | | Excellent | Excellent | Excellent | Excellent |
| Left stand for 2000 hrs at 85°C and 85% RH with sunshine weather meter | (ii) Sealant layer | Yellowing | Before | Excellent | Excellent | Excellent | Excellent |
| | | | After | Good | Good | Good | Good |
| | | Cracks | Before | Excellent | Excellent | Excellent | Excellent |
| | | | After | Good | Good | Good | Good |
| | | Bubbles | Before | Excellent | Excellent | Excellent | Excellent |
| | | | After | Good | Good | Good | Good |
| | (iii) Peeling | Glass | Before | Excellent | Excellent | Excellent | Excellent |
| | | plate | After | Good | Good | Good | Good |
| | | Back | Before | Excellent | Excellent | Excellent | Excellent |
| | | sheet | After | Good | Good | Good | Good |
| | (iv) Corrosion of aluminum plate | | Before | Excellent | Excellent | Excellent | Excellent |
| | | | After | Good | Good | Good | Good |
| Left stand for 2000 hrs at 85°C and 85% RH (in accordance with JIS C8917) | (ii) Sealant layer | Yellowing | Before | Excellent | Excellent | Excellent | Excellent |
| | | | After | Good | Good | Good | Good |
| | | Cracks | Before | Excellent | Excellent | Excellent | Excellent |
| | | | After | Good | Good | Good | Good |
| | | Bubbles | Before | Excellent | Excellent | Excellent | Excellent |
| | | | After | Good | Good. | Good | Good |
| | (iii) Peeling | Glass | Before | Excellent | Excellent | Excellent | Excellent |
| | | plate | After | Good | Good | Good | Good |
| | | Back | Before | Excellent | Excellent | Excellent | Excellent |
| | | sheet | After | Good | Good | Good | Good |
| | (iv) Corrosion of aluminum plate | | Before | Excellent | Excellent | Excellent | Excellent |
| | | | After | Good | Good | Good | Good |
| Left stand for 2000 hers in 10% sodium hydroxide aqueous solution at 23°C (in accordance with JIS K7114) | (ii) Sealant layer | Yellowing | Before | Excellent | Excellent | Excellent | Excellent |
| | | | After | Good | Good | Good | Good |
| | | Cracks | Before | Excellent | Excellent | Excellent | Excellent |
| | | | After | Good | Good | Good | Good |
| | | Bubbles | Before | Excellent | Excellent | Excellent | Excellent |
| | | | After | Good | Good | Good | Good |
| | (iii) Peeling | Glass | Before | Excellent | Excellent | Excellent | Excellent |
| | | plate | After | Good | Good | Good | Good |
| | | Back | Before | Excellent | Excellent | Excellent | Excellent |
| | | sheet | After | Good | Good | Good | Good |
| | (iv) Corrosion of aluminum plate | | Before | Excellent | Excellent | Excellent | Excellent |
| | | | After | Good | Good | Good | Good |

**(Table 2)**

| | | | | Comparative Example 1 | Comparative Examples 2 | Comparative Example 3 |
|---|---|---|---|---|---|---|
| (i) Sealant overflow and contamination | | | | Poor | Poor | Poor |
| Left stand for 2000 hrs at 85°C and 85% RH with sunshine weather meter | (ii) Sealant layer | Yellowing | Before | Excellent | Excellent | Excellent |
| | | | After | Poor | Poor | Poor |
| | | Cracks | Before | Excellent | Excellent | Excellent |
| | | | After | Poor | Poor | Poor |
| | | Bubbles | Before | Excellent | Excellent | Excellent |
| | | | After | Poor | Poor | Poor |
| | (iii) Peeling | Glass | Before | Excellent | Excellent | Excellent |
| | | plate | After | Poor | Poor | Poor |
| | | Back | Before | Excellent | Excellent | Excellent |
| | | sheet | After | Poor | Poor | Poor |
| | (iv) Corrosion of aluminum plate | | Before | Excellent | Excellent | Excellent |
| | | | After | Poor | Poor | Poor |
| Left stand for 2000 hrs at 85°C and 85% RH (in accordance with JIS C8917) | (ii) Sealant layer | Yellowing | Before | Excellent | Excellent- | Excellent |
| | | | After | Poor | Poor | Poor |
| | | Cracks | Before | Excellent | Excellent | Excellent |
| | | | After | Poor | Poor | Poor |
| | | Bubbles | Before | Excellent | Excellent | Excellent |
| | | | After | Poor | Poor | Poor |
| | (iii) Peeling | Glass | Before | Excellent | Excellent | Excellent |
| | | plate | After | Poor | Poor | Poor |
| | | Back | Before | Excellent | Excellent | Excellent |
| | | sheet | After | Poor | Poor | Poor |
| | (iv) Corrosion of aluminum plate | | Before | Excellent | Excellent | Excellent |
| | | | After | Poor | Poor | Poor |
| Left stand for 2000 hrs in 10% sodium hydroxide aqueous solution at 23°C (in accordance with JIS K7114) | (ii) Sealant layer | Yellowing | Before | Excellent | Excellent | Excellent |
| | | | After | Poor | Poor | Poor |
| | | Cracks | Before | Excellent | Excellent | Excellent |
| | | | After | Poor | Poor | Poor |
| | | Bubbles | Before | Excellent | Excellent | Excellent |
| | | | After | Poor | Poor | Poor |
| | (iii) peeling | Glass | Before | Excellent | Excellent | Excellent |
| | | plate | After | Poor | Poor | Poor |
| | | Back | Before | Excellent | Excellent | Excellent |
| | | sheet | After | Poor | Poor | Poor |
| | (iv) Corrosion of aluminum plate | | Before | Excellent | Excellent | Excellent |
| | | | After | Poor | Poor | Poor |

As apparent from (Table 1) and (Table 2), it is confirmed that the solar cell module having a high sealing property is easily manufactured by using the coating film of the specific water-soluble thermosetting resin particle paint as the sealant, without causing a problem in that the sealant in the plasticized state overflows to the periphery of the solar cell module, sticks to the assembly apparatus to cause contamination in the assembly step of the solar cell module.

### Industrial Applicability

As described above, the present invention can provide the solar cell sealant sheet and the sealant-integrated substrate that can seal and bond a solar cell element without causing a problem in that a sealant in the plasticized state overflows to the periphery of a solar cell module, and sticks to an assembly apparatus to cause contamination in the assembly step of the solar cell module.

### Reference Signs List

- 1: transparent plate
- 2: back surface protection sheet (back sheet)
- 3: solar cell element
- 4: sealant

## Claims

1. A solar cell sealant sheet for sealing a solar cell element between two kinds of substrates that are a light receiving side transparent plate and a back surface protection sheet, the solar cell sealant sheet having a thermosetting property, the solar cell sealant sheet comprising:
a coating film of a water-soluble thermosetting resin-dispersed paint obtained by emulsion-polymerizing a monomer mixture containing an α,β-ethylenically unsaturated monomer having an alkoxysilyl group in a presence of a resin serving as a dispersant, said resin having a quaternized ammonium group that has been obtained by addition of a tertiary amine compound and an organic acid to having an epoxy group, wherein
a hardness (B) in terms of a pencil hardness of the coating film after being thermally cured is 4B or higher, and a hardness ratio (B/A) of the hardness (B) after being thermally cured relative to a hardness (A) before being heated is 1.1 or higher.

2. The solar cell sealant sheet according to claim 1, wherein the coating film has a thickness ranging from 30 µm to 400 µm.

3. A sealant-integrated substrate for a solar cell that is for forming a solar cell module that has two kinds of substrates that are a light receiving side transparent plate and a back surface protection sheet, and a sealant that seals a solar cell element between the substrates,
the sealant-integrated substrate comprising, as the sealant, a coating film of a water-soluble thermosetting resin-dispersed paint obtained by emulsion-polymerizing a monomer mixture containing an α,β-ethylenically unsaturated monomer having an alkoxysilyl group in a presence of a resin serving as a. dispersant, said resin having a quaternized ammonium group that has been obtained by addition of a tertiary amine compound and an organic acid to having an epoxy group, wherein a hardness (B) in terms of a pencil hardness of the coating film after being thermally cured is 4B or higher, a hardness ratio (B/A) of the hardness (B) after being thermally cured relative to a hardness (A) before being heated is 1.1 or higher, and the coating film is integrally layered on a surface on a solar cell element side of the substrate.

4. The sealant-integrated substrate for a solar cell according to claim 3, wherein the substrate on which the sealant is integrally layered is the light receiving side transparent plate.

5. The sealant-integrated substrate for a solar cell according to claim 3, wherein the substrate on which the sealant is integrally layered is the back surface protection sheet.

6. The sealant-integrated substrate for a solar cell according to any one of claims 3 to 5, wherein the coating film has a thickness ranging from 30 µm to 400 µm.
